# EUROPEAN PATENT APPLICATION

(11) **EP 4 729 958 A1**
(43) Date of publication of application: **22.04.2026**
(21) Application number: 24823692.9
(22) Date of filing: 12.06.2024
(51) Int. Cl.: G01R 31/317, G01R 23/12, G01R 19/25, G01R 35/00, G01R 31/3167

(54) **APPARATUS AND METHOD FOR CONTROLLING PHASE OF MEASUREMENT WAVEFORM OF MU**

(30) Priority: 13.06.2023 KR 20230075706
(71) Applicant: Hyosung Heavy Industries Corporation, Seoul 04144 (KR)
(72) Inventor: KWON, Hyo Chul, Suwon-si Gyeonggi-do 16433 (KR); PARK, Cheol Min, Incheon 22663 (KR); LEE, Jin Young, Incheon 22663 (KR)
(74) Representative: Viering, Jentschura & Partner mbB Patent- und Rechtsanwälte
(86) International application number: PCT/KR2024/008046
(87) International publication number: WO 2024/258174

(57) **Abstract**

The present invention relates to a measured waveform phase control device and method of a merging unit (MU) which obtains an accurate value at a sampling command time, corrects characteristics of a change in temperature of an oscillator element, and also corrects delay characteristics of an analog sensing element at the sampling command time. A measured waveform phase control device of an MU of the present invention includes a temperature sensor which provides ambient temperature information, an oscillator element which provides an oscillation signal, an analog-digital converter (ADC) which samples an analog current sensing signal or voltage sensing signal as a digital signal, and a sampling clock providing part which provides a sampling clock to the ADC on the basis of the ambient temperature information and the oscillation signal under control of a sampling request part.

## Description

### [Technical Field]

The present invention relates to a measured waveform phase control device and method of a merging unit (MU), and more specifically, to correcting a phase for a delay time of an analog sensing element. In addition, the present invention relates to a measured waveform phase control device and method of an MU capable of accurately extracting sensing values of a voltage and a current of an MU at a sampling command time.

### [Background Art]

Equipment related to power systems is networked, and one of the pieces of equipment is a merging unit (MU) which collects an amount of system electricity from the power system.

Generally, an MU is a device which converts an input analog voltage/current signal output from a transformer into a digital value, configures the converted digital value into an IEC 61850 Sampled Value format, and transmits the configured value.

According to a function of an MU, an analog voltage/current signal should be measured at an exact time according to a sampling command, but a certain level of phase angle delay occurs between a voltage and current signal input to the MU and an output value of the MU.

Accordingly, studies for reducing such errors have been continuously conducted. As an example, Korean Laid-open Patent Publication No. 10-2015-7035504 proposed a distribution type protection relay device capable of matching phases of digital data of a plurality of MUs.

However, even in this case, there are disadvantages that an accurate value at a sampling command time cannot be obtained through phase correction, and particularly, a change in sampling time according to a change in temperature cannot be accommodated.

### [Technical Problem]

The present invention is directed to providing a measured waveform phase control device and method of a merging unit (MU) which obtains an accurate value at a sampling command time.

The present invention is directed to providing a measured waveform phase control device and method of an MU which corrects characteristics of a change in temperature of an oscillator element and also corrects delay characteristics of an analog sensing element at a sampling command time.

### [Technical Solution]

In accordance with one aspect of the present invention, there is provided a measured waveform phase control device of a merging unit (MU), including a temperature sensor which provides ambient temperature information, an oscillator element which provides an oscillation signal, an analog-digital converter (ADC) which samples an analog current sensing signal or voltage sensing signal as a digital signal, and a sampling clock providing part which provides a sampling clock to the ADC on the basis of the ambient temperature information and the oscillation signal under control of a sampling request part.

In this case, delay time characteristics of the current sensing signal or the voltage sensing signal at room temperature may be input to the sampling clock providing part.

In addition, the inputting of the delay time characteristics of the current sensing signal or the voltage sensing signal at the room temperature may be performed by measuring a value required for phase correction at the room temperature, correcting an A-phase voltage phase first, and correcting a B-phase voltage phase and a C-phase voltage phase on the basis of the corrected A-phase voltage phase and by sequentially correcting an A-phase current phase, a B-phase current phase, and a C-phase current phase on the basis of the corrected A-phase voltage phase.

In this case, the value required for phase correction may be determined according to individual characteristics of a sensor for current sensing or voltage sensing.

In addition, the sampling clock providing part may control a timing of the sampling clock on the basis of the ambient temperature information.

In this case, the sampling clock providing part may provide a delayed sampling time, which is delayed from a reference sampling time by a delay time between an original waveform and a measured waveform obtained by measuring the original waveform, as the sampling clock.

In addition, the sampling clock providing part may provide a corrected sampling time, which is corrected by an oscillation speed difference which is a time difference between a first delayed sampling time generated on the basis of a first oscillation speed at room temperature and a second delayed sampling time generated on the basis of a second oscillation speed when the ambient temperature information is different from the room temperature, as the sampling clock.

In accordance with another aspect of the present invention, there is provided a method of controlling a phase of a measured waveform of an MU, including a first phase control operation of controlling, by a sampling clock providing part, a sampling clock of an analog-digital converter (ADC) to control a phase of a current sensing signal or voltage sensing signal on the basis of delay time characteristics of the current sensing signal or the voltage sensing signal at room temperature and a second phase control operation of controlling a timing of the sampling clock on the basis of ambient temperature information.

In this case, the first phase control operation may include a phase correction value measurement operation of measuring a value required for phase correction, an A-phase voltage phase correction operation of correcting an A-phase voltage phase, a B-phase and C-phase voltage phase correction operation of correcting a B-phase voltage phase and a C-phase voltage phase on the basis of the corrected A-phase voltage phase, and an A-phase, B-phase, and C-phase current phase correction operation of correcting an A-phase current phase, a B-phase current phase, and a C-phase current phase on the basis of the corrected A-phase voltage phase.

In this case, the value required for phase correction may be determined according to individual characteristics of a sensor for current sensing or voltage sensing.

In addition, the second phase control operation may include a temperature compensation information input operation of inputting an oscillation speed difference of an oscillator element due to a temperature difference to the sampling clock providing part, a temperature difference calculation operation of measuring, by a temperature sensor, an ambient temperature and calculating the temperature difference, a temperature compensation information matching operation of checking, by the sampling clock providing part, the oscillation speed difference due to the temperature difference, and a sampling time correction operation of correcting the timing of the sampling clock by the oscillation speed difference.

In this case, in the second phase control operation, a delayed sampling time delayed from a reference sampling time by a delay time between an original waveform and a measured waveform obtained by measuring the original waveform may be provided as the sampling clock.

In addition, in the second phase control operation, a corrected sampling time corrected by the oscillation speed difference which is a time difference between a first delayed sampling time generated on the basis of a first oscillation speed at the room temperature and a second delayed sampling time generated on the basis of a second oscillation speed when the ambient temperature information is different from the room temperature may be provided as the sampling clock.

### [Advantageous Effects]

A measured waveform phase control device and method of a merging unit (MU) according to the present invention has an advantage of obtaining an accurate value at a sampling command time.

In addition, a measured waveform phase control device and method of an MU according to the present invention has advantages of correcting characteristics of a change in temperature of an oscillator element and also correcting delay characteristics of an analog sensing element at a sampling command time.

### [Description of Drawings]

FIG. 1 is a schematic block diagram illustrating a measured waveform phase control device of a merging unit (MU) according to one embodiment of the present invention.
FIG. 2 shows a waveform and a timing diagram illustrating a measured waveform input to an analog-digital converter (ADC) of FIG. 1, wherein FIG. 2A is a view showing comparison waveforms of an original waveform and a measured waveform, and FIG. 2B is a timing diagram showing in detail a reference sampling time corresponding to the original waveform and a delayed sampling time corresponding to the measured waveform.

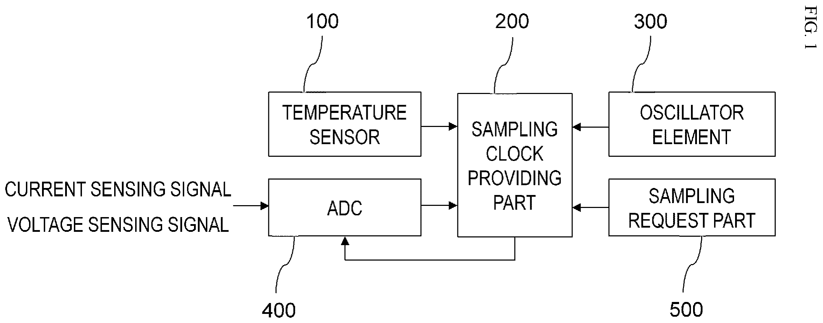

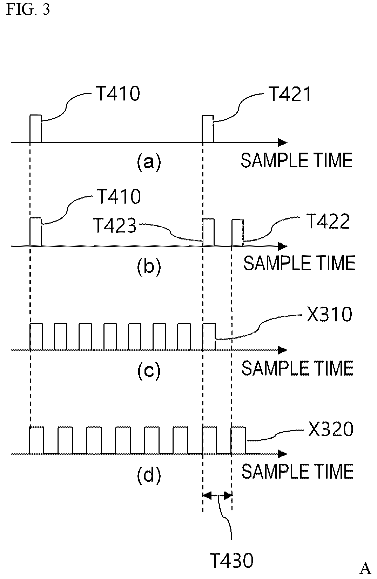

FIG. 3 shows timing diagrams of sampling clocks used in the ADC of FIG. 1, wherein FIG. 3A shows a first delayed sampling time at room temperature with respect to the reference sampling time, FIG. 3B shows a second delayed sampling time at an ambient temperature, which is not room temperature, with respect to the reference sampling time and a corrected sampling time obtained by correcting the second delayed sampling time, FIG. 3C shows a first oscillation speed of an oscillator element at room temperature, and FIG. 3D shows a second oscillation speed of the oscillator element at an ambient temperature which is not room temperature.
FIG. 4 is a flowchart showing a method of controlling a phase of a measured waveform of an MU according to one embodiment of the present invention.
FIG. 5 is a flowchart showing a first phase control operation of FIG. 4 in detail.
FIG. 6 is a flowchart showing a second phase control operation of FIG. 4 in detail.

### [Modes of the Invention]

Hereinafter, specific embodiments for implementing the present invention will be described with reference to the accompanying drawings.

Although terms such as "first," "second," and the like may be used to describe various components, the components are not limited by these terms. These terms are only used to distinguish one component from another component. For example, a first component may be named a second component, and similarly, a second component may also be named a first component without departing from the scope of the present invention.

When a first element is referred to as being "connected" or "coupled" to a second element, it will be understood that the first element may be directly connected or coupled to the second element, or a third element may be present therebetween.

Terms used in the present specification are for the purpose of describing particular embodiments only and are not intended to limit the present invention. The singular forms include the plural forms, unless the context clearly indicates otherwise.

It may be understood that terms "comprise," "include," and the like herein specify the presence of stated features, numbers, steps, operations, elements, components, or combinations thereof but do not preclude the presence or addition of one or more other features, numbers, steps, operations, elements, components, or combinations thereof.

In addition, the shapes and sizes of elements in the drawings may be exaggerated for clearer description.

Hereinafter, a measured waveform phase control device and method of a merging unit (MU) according to the present invention will be described in detail with reference to the accompanying drawings.

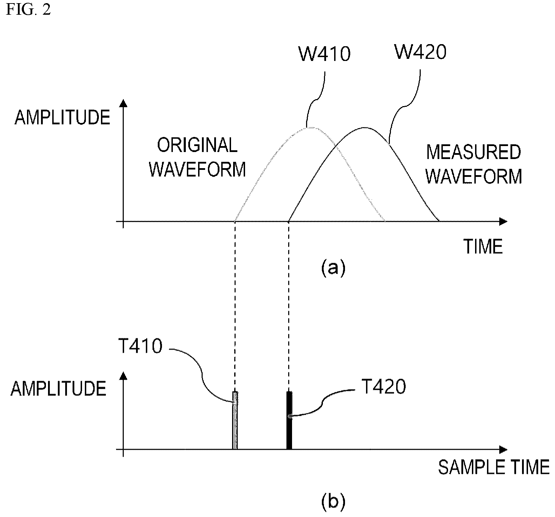

FIG. 1 is a schematic block diagram illustrating a measured waveform phase control device of an MU according to one embodiment of the present invention. FIGS. 2 and 3 are detailed timing diagrams for describing FIG. 1 in detail.

Hereinafter, the measured waveform phase control device of an MU according to one embodiment of the present invention will be described with reference to FIGS. 1 to 3.

First, referring to FIG. 1, the measured waveform phase control device of an MU according to one embodiment of the present invention includes a temperature sensor 100 for providing ambient temperature information, an oscillator element 300 for providing an oscillation signal, an analog-digital converter (ADC) 400 for sampling an analog current sensing signal or voltage sensing signal as a digital signal, and a sampling clock providing part 200 for providing a sampling clock to the ADC 400 under the control of a sampling request part 500 on the basis of the ambient temperature information and the oscillation signal.

In this case, an MU should sample an analog current sensing signal or voltage sensing signal as a digital signal at a sampling request time required from the outside. In this case, a sensor (not shown) for current sensing or voltage sensing is required, and a measured value is input to the ADC 400 after a delay occurring in the sensor.

Generally, in order to overcome such a difference due to a delay time, a phase is corrected by software, but there is a problem that the difference is not an accurate real time value, and there is a disadvantage that the difference varies according to ambient temperature information.

In order to overcome this, in the measured waveform phase control device of an MU according to the present invention, delay time characteristics of a current sensing signal or voltage sensing signal at room temperature are input to the sampling clock providing part 200 to control the timing of a sampling clock on the basis of ambient temperature information during operation.

In the present invention, the inputting of the delay time characteristics at room temperature is performed by measuring a value required for phase correction at room temperature, correcting an A-phase voltage phase first, and correcting a B-phase voltage phase and a C-phase voltage phase on the basis of the corrected A-phase voltage phase. In addition, the inputting is performed by sequentially correcting an A-phase current phase, a B-phase current phase, and a C-phase current phase on the basis of the corrected A-phase voltage phase.

In this case, the value required for phase correction is determined according to individual characteristics of the sensor for current sensing or voltage sensing and may be measured by a separate measuring instrument and input to the sampling clock providing part 200.

As described above, in the present invention, as the delay time characteristics at room temperature are input, an accurate analog current sensing signal or voltage sensing signal may be sampled as a digital signal in real time and transmitted to an upper-level device regardless of a delay time, and a detailed description thereof will be described with reference to FIGS. 2 and 3.

FIG. 2 shows a waveform and a timing diagram illustrating a measured waveform W420 input to the ADC 400 of FIG. 1, wherein FIG. 2A is a view showing comparison waveforms of an original waveform W410 and the measured waveform W420, and FIG. 2B is a timing diagram showing in detail a reference sampling time T410 corresponding to the original waveform W410 and a delayed sampling time T420 corresponding to the measured waveform W420.

As can be seen in FIG. 2, the sampling clock providing part 200 provides the delayed sampling time T420, which is delayed from the reference sampling time T410, which is a sampling request time, by a delay time between the original waveform W410 at the sampling request time and the measured waveform W420 obtained by measuring the original waveform W410, as a sampling clock.

Accordingly, the present invention can accurately compensate for a time delayed in the sensor (not shown) for current sensing or voltage sensing, and hereinafter, a case, in which ambient temperature information does not correspond to room temperature, will be described in detail with reference to FIG. 3.

FIG. 3 shows timing diagrams of sampling clocks used in the ADC 400 of FIG. 1, wherein FIG. 3A shows a first delayed sampling time T421 at room temperature with respect to the reference sampling time T410, FIG. 3B shows a second delayed sampling time T422 at an ambient temperature, which is not room temperature, with respect to the reference sampling time T 410 and a corrected sampling time T423 obtained by correcting the second delayed sampling time T422, FIG. 3C shows a first oscillation speed X310 of the oscillator element 300 at room temperature, and FIG. 3D shows a second oscillation speed X320 of the oscillator element 300 at an ambient temperature which is not room temperature.

Generally, since an oscillation speed of the oscillator element 300 varies according to a temperature, the oscillator element 300 has a disadvantage that the oscillator element 300 cannot provide an accurate sampling clock to the ADC 400.

In FIG. 3, the first delayed sampling time T421 shows a case in which the oscillator element 300 oscillates at the first oscillation speed X310 at room temperature, and the second delayed sampling time T422 shows a case in which the oscillator element 300 oscillates at the second oscillation speed X320 at a temperature which is not room temperature.

In this case, the sampling clock providing part 200 provides the corrected sampling time T423 corrected by an oscillation speed difference T430, which is a time difference between the first delayed sampling time T421 generated on the basis of the first oscillation speed X310 at room temperature and the second delayed sampling time T422 generated on the basis of the second oscillation speed X320 when ambient temperature information is different from room temperature, as a sampling clock.

Accordingly, the measured waveform phase control device of an MU according to the present invention has an advantage of accurately compensating for a time delayed in the sensor (not shown) for current sensing or voltage sensing even when ambient temperature information does not correspond to room temperature.

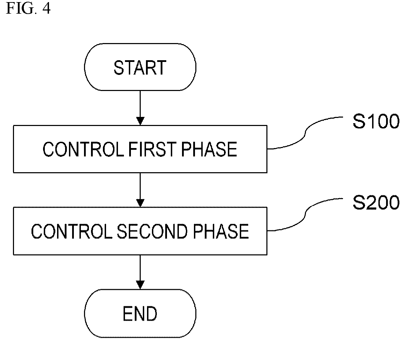

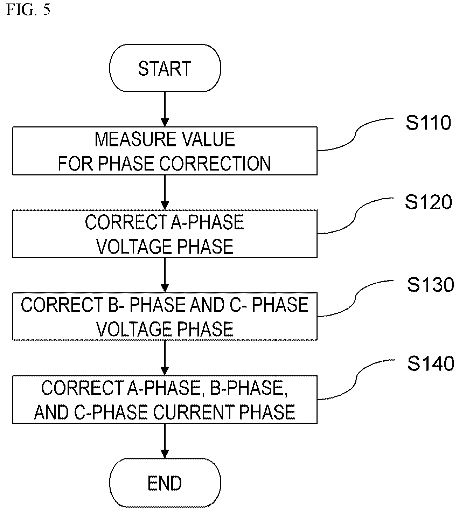

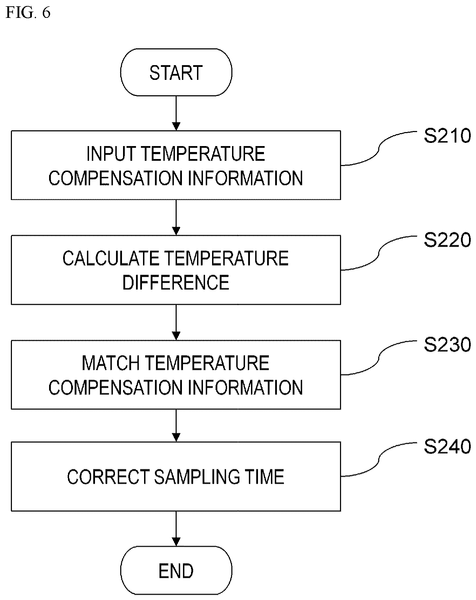

FIG. 4 is a flowchart showing a method of controlling a phase of a measured waveform of an MU according to one embodiment of the present invention, and FIGS. 5 and 6 are flowcharts for describing FIG. 4 in detail. Hereinafter, the method of controlling a phase of a measured waveform of an MU according to one embodiment of the present invention will be described with reference to FGIS. 4 to 6.

First, referring to FIG. 4, the method of controlling a phase of a measured waveform of an MU according to one embodiment of the present invention may control the timing of a sampling clock through two phase control operations.

That is, first, the method of controlling a phase of a measured waveform of an MU according to the present invention includes a first phase control operation S 100 of controlling, by the sampling clock providing part 200, a sampling clock of the ADC 400 on the basis of delay time characteristics of a current sensing signal or voltage sensing signal at room temperature to control a phase of the current sensing signal or voltage sensing signal and a second phase control operation S200 of controlling the timing of the sampling clock on the basis of ambient temperature information after the first phase control operation S 100, and the detailed operations thereof will be described with reference to FIGS. 5 and 6.

FIG. 5 is a flowchart showing the first phase control operation S100 of FIG. 4 in detail.

As can be seen in FIG. 5, the first phase control operation S100 of the present invention includes a phase correction value measurement operation S110 of measuring a value required for phase correction to correct a phase of an initial stage, an A-phase voltage phase correction operation S 120 of correcting an A-phase voltage phase, a B-phase and C-phase voltage phase correction operation S130 of correcting a B-phase voltage phase and a C-phase voltage phase on the basis of the corrected A-phase voltage phase, and an A-phase, B-phase, and C-phase current phase correction operation S 140 of correcting an A-phase current phase, a B-phase current phase, and a C-phase current phase on the basis the corrected A-phase voltage phase.

In this case, the value required for phase correction is determined according to individual characteristics of the sensor for current sensing or voltage sensing and may be measured by a separate measuring instrument and input to the sampling clock providing part 200.

Meanwhile, in the present invention, when ambient temperature information does not correspond to room temperature, the phase corrected in the first phase control operation S100 may vary, which will be described in detail with reference to FIG. 6.

FIG. 6 is a detailed flowchart showing the second phase control operation S200 of FIG. 4 in detail.

As can be seen in FIG. 6, the second phase control operation S200 of the present invention includes a temperature compensation information input operation S210 of inputting an oscillation speed difference T430 of the oscillator element 300 due to a temperature difference to the sampling clock providing part 200, a temperature difference calculation operation S220 of measuring, by the temperature sensor 100, an ambient temperature and calculating a temperature difference, a temperature compensation information matching operation S230 of checking, by the sampling clock providing part 200, the oscillation speed difference T430 due to the temperature difference, and a sampling time correction operation S240 of correcting the timing of a sampling clock by the oscillation speed difference T430.

More specifically, as in FIG. 3, the present invention provides a corrected sampling time T423, which is corrected by the oscillation speed difference T430 which is a time difference between a first delayed sampling time T421 generated on the basis of a first oscillation speed X310 at room temperature and a second delayed sampling time T422 generated on the basis of a second oscillation speed X320 when ambient temperature information is different from room temperature, as a sampling clock.

Accordingly, the method of controlling a phase of a measured waveform of an MU according to the present invention can accurately compensate for a time delayed in the sensor for current sensing or voltage sensing (not shown) even when ambient temperature information does not correspond to room temperature.

As described above, the measured waveform phase control device and method of an MU according to the present invention has advantages of obtaining an accurate value at a sampling command time, correcting characteristics of the oscillator element changed due to a temperature, and also correcting delay characteristics of an analog sensing element due to a sampling command time.

Those skill in the art will understand that described various exemplary logical blocks, modules, processors, means, circuits, and algorithmic operations related to the embodiments disclosed herein may be implemented by electronic hardware, various types of programs or design code (for the sake of convenience, referred to as software herein), or combinations thereof. In order to clearly describe such interchangeability of hardware and software, various exemplary components, blocks, modules, circuits, and operations have been generally described above in relation to their functions. Whether such functions are implemented as hardware or software depends on design constraints applied to particular applications and entire systems. Those skilled in the art may implement functions described in various ways for each specific application, but these implementations should not be interpreted as not being included in the scope of the present invention.

The various embodiments disclosed herein may be implemented using methods, devices, or manufactured articles using standard programming and/or engineering techniques. The term "manufactured articles" include computer programs, carriers, or media accessible from any computer-readable storage device. For example, the computer-readable storage media include, magnetic storage devices (such as, hard disks, floppy disks, and magnetic strips), optical disks (such as, compact discs (CDs) and digital versatile disc (DVDs)), smart cards, and flash memory devices (such as, electrically erasable programmable read-only memories (EEPROMs), cards, sticks, and key drives) but are not limited thereto. In addition, various storage media disclosed herein include one or more devices for storing information and/or other machine-readable media.

It should be understood that a specific order or hierarchy of operations in disclosed processes is an example of exemplary approaches. Based on design priorities, it should be understood that the specific order or hierarchy of the operations in the processes may be rearranged within the scope of the present invention. The appended method claims provide elements of the various operations as a sample order, but do not mean that they are limited to the disclosed specific order or hierarchy.

The description of the disclosed embodiments is provided so that those skill in the art may use or implement the present invention. Various modifications of the embodiments will be apparent to those skilled in the art, and general principles defined herein may be applied to other embodiments without departing from the scope of the present invention. Therefore, the present invention is not limited to the embodiments disclosed herein, and should be interpreted to have the widest scope consistent with the principles and novel features disclosed herein.

### [Industrial Applicability]

The present invention relates to a measured waveform phase control device and method of a merging unit (MU) and can be used in the MU field.

## Claims

1. A measured waveform phase control device of a merging unit (MU), comprising:
a temperature sensor which provides ambient temperature information;
an oscillator element which provides an oscillation signal;
an analog-digital converter (ADC) which samples an analog current sensing signal or voltage sensing signal as a digital signal; and
a sampling clock providing part which provides a sampling clock to the ADC on the basis of the ambient temperature information and the oscillation signal under control of a sampling request part.

2. The measured waveform phase control device of claim 1, wherein delay time characteristics of the current sensing signal or the voltage sensing signal at room temperature are input to the sampling clock providing part.

3. The measured waveform phase control device of claim 2, wherein the inputting of the delay time characteristics of the current sensing signal or the voltage sensing signal at the room temperature is performed by measuring a value required for phase correction at the room temperature, correcting an A-phase voltage phase first, and correcting a B-phase voltage phase and a C-phase voltage phase on the basis of the corrected A-phase voltage phase and by sequentially correcting an A-phase current phase, a B-phase current phase, and a C-phase current phase on the basis of the corrected A-phase voltage phase.

4. The measured waveform phase control device of claim 3, wherein the value required for phase correction is determined according to individual characteristics of a sensor for current sensing or voltage sensing.

5. The measured waveform phase control device of claim 1, wherein the sampling clock providing part controls a timing of the sampling clock on the basis of the ambient temperature information.

6. The measured waveform phase control device of claim 1, wherein the sampling clock providing part provides a delayed sampling time, which is delayed from a reference sampling time by a delay time between an original waveform and a measured waveform obtained by measuring the original waveform, as the sampling clock.

7. The measured waveform phase control device of claim 5, wherein the sampling clock providing part provides a corrected sampling time, which is corrected by an oscillation speed difference which is a time difference between a first delayed sampling time generated on the basis of a first oscillation speed at room temperature and a second delayed sampling time generated on the basis of a second oscillation speed when the ambient temperature information is different from the room temperature, as the sampling clock.

8. A method of controlling a phase of a measured waveform of a merging unit (MU), comprising:
a first phase control operation of controlling, by a sampling clock providing part, a sampling clock of an analog-digital converter (ADC) to control a phase of a current sensing signal or voltage sensing signal on the basis of delay time characteristics of the current sensing signal or the voltage sensing signal at room temperature; and
a second phase control operation of controlling a timing of the sampling clock on the basis of ambient temperature information.

9. The method of claim 8, wherein the first phase control operation includes:
a phase correction value measurement operation of measuring a value required for phase correction;
an A-phase voltage phase correction operation of correcting an A-phase voltage phase;
a B-phase and C-phase voltage phase correction operation of correcting a B-phase voltage phase and a C-phase voltage phase on the basis of the corrected A-phase voltage phase; and
an A-phase, B-phase, and C-phase current phase correction operation of correcting an A-phase current phase, a B-phase current phase, and a C-phase current phase on the basis of the corrected A-phase voltage phase.

10. The method of claim 9, wherein the value required for phase correction is determined according to individual characteristics of a sensor for current sensing or voltage sensing.

11. The method of claim 8, wherein the second phase control operation includes:
a temperature compensation information input operation of inputting an oscillation speed difference of an oscillator element due to a temperature difference to the sampling clock providing part;
a temperature difference calculation operation of measuring, by a temperature sensor, an ambient temperature and calculating the temperature difference;
a temperature compensation information matching operation of checking, by the sampling clock providing part, the oscillation speed difference due to the temperature difference; and
a sampling time correction operation of correcting the timing of the sampling clock by the oscillation speed difference.

12. The method of claim 11, wherein, in the second phase control operation, a delayed sampling time delayed from a reference sampling time by a delay time between an original waveform and a measured waveform obtained by measuring the original waveform is provided as the sampling clock.

13. The method of claim 12, wherein, in the second phase control operation, a corrected sampling time corrected by the oscillation speed difference which is a time difference between a first delayed sampling time generated on the basis of a first oscillation speed at the room temperature and a second delayed sampling time generated on the basis of a second oscillation speed when the ambient temperature information is different from the room temperature is provided as the sampling clock.
